# EUROPÄISCHE PATENTSCHRIFT

(11) **EP 0 735 678 B1**
(45) Veröffentlichungstag und Bekanntmachung des Hinweises auf die Patenterteilung: **17.05.2000**
(21) Anmeldenummer: 96103554.0
(22) Anmeldetag: 06.03.1996
(51) Int. Cl.: H03K 3/0231, H03K 3/03

(54) **Monolithisch integrierter Oszillator**
Monolithically integrated oscillator
Oscillateur intégré monolithiquement

(30) Priorität: 28.03.1995 DE 19511401
(43) Veröffentlichungstag der Anmeldung: 02.10.1996
(73) Patentinhaber: SIEMENS AKTIENGESELLSCHAFT, 80333 München (DE)
(72) Erfinder: Heppner, Björn Haiko, Dr.-Ing., 82229 Seefeld (DE); Unterricker, Reinhold, Dr.-Ing., 81369 München (DE)

(56) Entgegenhaltungen:
- US-A- 4 375 621
- US-A- 4 523 158
- US-A- 4 905 257
- US-A- 5 148 125

## Beschreibung

In vielen integrierten Schaltungen der Telekommunikationstechnik werden im Frequenzbereich von einigen hundert Megahertz bis zu mehreren Gigahertz arbeitende Oszillatoren benötigt. Mit modernen bipolaren Silizium-Halbleitertechnologien können solche Schaltungen als Ringoszillatoren ohne externe Elemente auf einen Chip integriert werden. Dabei ist die Schwingungsfrequenz jedoch stark von der Betriebstemperatur des Chips und von Streuungen der Halbleiterparameter abhängig. Der Einsatz von Oszillatoren mit geringer Grundgenauigkeit erfordert daher beispielsweise in TaktrückgewinnungsSchaltungen aufwendige Hilfsschaltungen wie Referenz-Phasenregelschleifen (IEEE J. of Solid-State Circuits, 28(1993)12, 1310 ... 1313) bzw. externe Komponenten wie Quarzkristalle (IEEE 1991 Bipolar Circuits and Technology Meeting 12.4, 293 ... 296), die die Gesamtschaltung komplexer und den Aufbau teurer machen. Weiter ist ein großer Durchstimmbereich des Oszillators notwendig, um die anfängliche Frequenzablage ausregeln zu können, was zu erhöhtem Phasenrauschen (Jitter) führt und bei sehr hohen Frequenzen (über 5 GHz) auch schwierig zu realisieren ist.

Auch bei Verwendung von Bonddrähten als frequenzbestimmende Elemente eines Oszillators (ELECTRONICS LETTERS, 30(1994)3, 244 ... 245) ist aufgrund der Fertigungstoleranzen beim Bonden keine Grundgenauigkeit zu erwarten, die für eine Taktrückgewinnungsschaltung ohne Referenz-Phasenregelschleife bzw. externen Abgleich ausreicht.

Aus der US-Patentschrift US-A-4 905 257 ist ein monolithisch integrierter Ringoszillator bekannt. Dieser weist einen Leitungstreiber sowie eine rückkoppelnde Leitung auf. Bezeichnend an einer derartigen Vorrichtung ist, daß sie um eine hohe Genauigkeit zu erreichen, relativ schaltungsaufwendig ist.

Die Erfindung zeigt demgegenüber einen Weg zu einem weniger schaltungsaufwendigen Oszillator hoher Genauigkeit.

Die Erfindung betrifft einen monolithisch integrierten Ringoszillator mit den Merkmalen gemäß Anspruch 1, wobei die Laufzeit der Doppelleitung in weiterer Ausgestaltung der Erfindung grösser als (und möglichst groß gegen) die Verzögerungszeit des Leitungstreibers ist: Je kleiner die Verzögerungszeit des Leitungstreibers ist und je grösser demgegenüber die Laufzeit der Doppelleitung, desto grösser ist die Unabhängigkeit der Oszillatorfrequenz von parameter- und temperaturbedingten Änderungen der Verzögerungszeit des Leitungstreibers.

Die Erfindung bringt den Vorteil mit sich, daß sich der bei einem Einsatz in Taktrückgewinnungsschaltungen bei gewöhnlichen, nur aus Invertern (als frequenzbestimmenden Elementen) aufgebauten Ringoszillatoren notwendige Aufwand zur Vorabstimmung, beispielsweise mittels einer Referenz-Phasenregelschleife, erübrigt.

Es sei an dieser Stelle bemerkt, daß es (aus radio fernsehen elektronik 29(1980)9, 596 - 597) bekannt ist, daß ein Oszillator als invertierender Verstärker mit einem Laufzeitspeicher in der Rückführung ausgebildet sein kann, dessen Verzögerungszeit mindestens so groß sein muß, daß die Reaktion des Inverterausganges auf die Eingangsflanke über die Rückführung erst nach Beendigung der Eingangsflanke eintrifft, wobei die Schwingfrequenz bei Vernachlässigung der Inverterschaltzeit dem reziproken Wert der doppelten Verzögerungszeit des Laufzeitspeichers entspricht und durch alle Zeitvorgänge des Inverters anteilmäßig herabgesetzt wird. Irgendein Hinweis auf eine Integration einer rückkoppelnden Doppelleitung möglichst großer Laufzeit und eines Leitungstreibers möglichst kleiner Verzögerungszeit auf ein und demselben Chip wird dabei nicht gegeben.

Weitere Besonderheiten der Erfindung werden aus der nachfolgenden näheren Erläuterung eines Ausführungsbeispiels anhand der Zeichnungen ersichtlich. Dabei zeigen
- FIG 1: das Prinzipschaltbild eines Leitungs-Ringoszillators gemäß der Erfindung und
- FIG 2: ein Blockschaltbild einer Oszillatorschaltung gemäß der Erfindung;
- FIG 3: zeigt schaltungstechnische Einzelheiten eines Leitungstreibers.

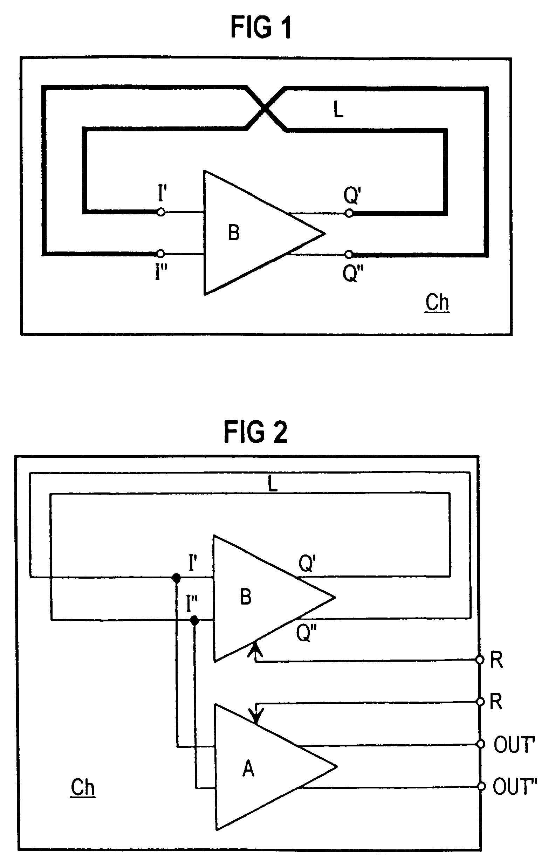

Die Zeichnung FIG 1 zeigt schematisch in einem zum Verständnis der Erfindung erforderlichen Umfang einen auf einem Chip Ch integrierten Leitungs-Ringoszillator mit einem Leitungstreiber B und einer auf dem Chip geführten Doppelleitung L, die die Ausgänge Q', Q" des Leitungstreibers B invertiert auf dessen Eingänge I', I" rückkoppelt. Ein solcher Leitungs-Ringoszillator kann beispielsweise in Siemens-B6HF-Bipolartechnologie realisiert sein. Die Periodendauer der erzeugten Schwingung ergibt sich als das Doppelte der Summe aus der Verzögerungszeit T_{B} des Leitungstreibers B und der Laufzeit T_{L} der Doppelleitung L. Die Laufzeit T_{L} der Leitung L hängt primär von der sehr gut reproduzierbaren Leitungslänge und der kaum streuenden Dielektrizitätszahl des Siliziumdioxids ab; die Schwingungsfrequenz des so gebildeten Ringoszillators ist somit wenig von Temperatur- und Parameterschwankungen abhängig. Um von der parameter- und temperaturabhängigen Verzögerungszeit T_{B} des Leitungstreibers B möglichst unabhängig zu sein, soll T_{B} möglichst klein und T_{L} möglichst groß sein.

Beispielsweise kann der Leitungstreiber B zur Erzeugung einer 5-GHz-Schwingung durch eine ca. 7 mm lange Doppelleitung L rückgekoppelt sein, die, aus 2 µm breiten Aluminiumbahnen mit einem gegenseitigen Abstand von 2 µm gebildet, (insbesondere in einer dritten Al-Schicht) über einer auf Massepotential liegenden Metallfläche (ggf. erste Al-Schicht) verläuft und einen Wellenwiderstand von ca. 50 Ohm besitzt; die Laufzeit beträgt ca. 70 ps. Die Leitung führt nach einer Überkreuzung zum Eingang des Leitungstreibers B, der im betrachteten Beispiel eine Verzögerungszeit von ca. 30 ps besitzt.

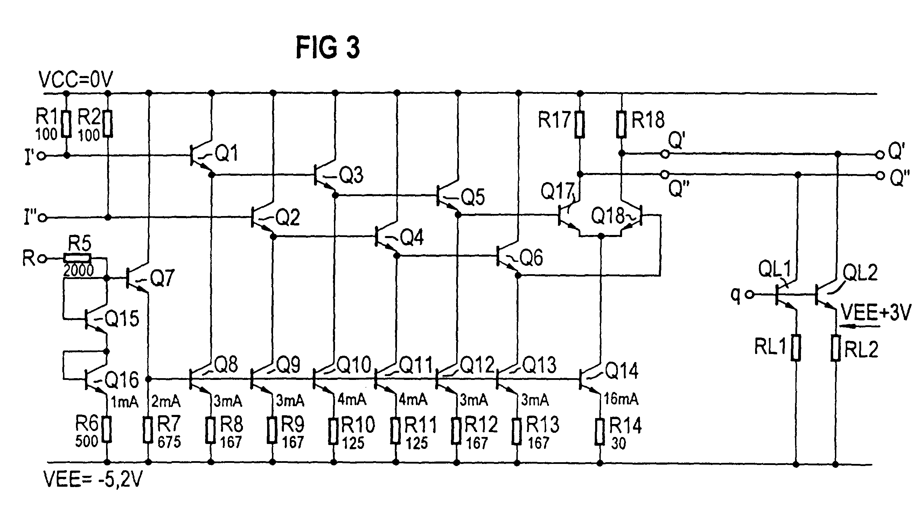

Das im Oszillator B,L erzeugte Signal wird zweckmäßigerweise über einen Auskoppelverstärker A zum Ausgang OUT', OUT" der Oszillatorschaltung geführt, wie dies aus FIG 2 ersichtlich ist. Leitungstreiber B und Auskoppelverstärker A können dabei in gleichartiger Weise mit einer Treiberschaltung realisiert sein, wie sie beispielsweise in FIG 3 skizziert ist.

In der in FIG 3 dargestellten Leitungstreiberschaltung werden die Pegel der über die Doppelleitung L (in FIG 1 und FIG 2) rückgekoppelten Signale mit Hilfe von stromquellengespeisten Transistoren Q1, Q3, Q5, bzw Q2, Q4, Q6 verschoben und dann einem Differenzverstärker mit zwei emittergekoppelten Transistoren Q17, Q18 zugeführt, dessen Ausgänge die Treiberausgänge bilden. Mit den Transistoren Q15, Q16 und Q7 und den Widerständen R5, R6 und R7 wird eine an einem Pin R einstellbare Vorspannung für die Stromquellentransistoren Q8 bis Q14 erzeugt.
Für das Ausführungsbeispiel sind in FIG 3 Widerstandswerte in Ohm angegeben, wobei die Widerstände R17, R18 zweckmäßigerweise im Leitungstreiber B einen Widerstandswert von 100 Ω und im Auskoppelverstärker A einen Widerstandswert von 50 Ω haben; die in FIG 3 angegebenen Stromwerte gelten für volle Aussteuerung der Schaltung am Eingang R.

Bei einem mit einer solchen Leitungstreiberschaltung gebildeten Leitungs-Ringoszillator kann die Oszillatorfrequenz im Temperaturbereich von 25 bis 125°C und im von Halbleiterherstellern spezifizierten Streubereich der Technologieparameter um 2,5 % schwanken. Diese hohe Genauigkeit ist entscheidend wichtig für einen Einsatz in Taktrückgewinnungsschaltungen.

Die Empfindlichkeit der Oszillatorfrequenz gegenüber relativen Änderungen des Leitungstreiberstromes beträgt ca. 0,1, d.h. bei einer Stromänderung von 10 % ändert sich die Schwingungsfrequenz um 1 %. Bei einem Einsatz in einer Phasenregelschleife (z.B. zur Taktrückgewinnung) kann der Oszillator somit durch entsprechende Aussteuerung des Leitungstreibers B von seinem Steuereingang R (in FIG 2 und 3) her auf eine bestimmte Empfangsfrequenz abgestimmt werden.

Man kann die Schwingungsfrequenz auch dadurch beeinflussen, daß die Leitung L (in FIG 1 und 2) mit steuerbaren Kapazitäten belastet wird. Dies kann beispielsweise mit spannungsabhängigen Sperrschichtkapazitäten geschehen, wie dies auch in FIG 3 verdeutlicht wird. Gemäß FIG 3 belasten Transistoren QL1 und QL2 mit ihrer Kollektor-Sperrschicht-Kapazität die Ausgänge Q' und Q" und bewirken dadurch eine zusätzliche Signalverzögerung. Wird der durch diese Transistoren fliessende Gleichstrom vom Steuereingang q her erhöht, so sinkt durch den zusätzlichen Spannungsabfall an den Differenzverstärker-Ausgangswiderständen R18 und R17 die mittlere Spannung an den Treiberausgängen Q' und Q". Aufgrund der damit kleineren Kollektor-Basis-Spannung nimmt die Kollektor-Sperrschicht-Kapazität sowohl der Lasttransistoren QL1 und QL2 als auch der Stromschaltertransistoren Q18 und Q17 zu, und die Verzögerung wird größer. Die Treibereingänge I', I" werden dabei zweckmäßigerweise kapazitiv an die Leitung L (in FIG 1 und FIG 2) gekoppelt sein, um zu vermeiden, daß das Basispotential der Stromschaltertransistoren Q18 und Q17 zu klein wird. Ohne daß dies hier noch im einzelnen dargestellt werden muß, können ggf. weitere Sperrschichtkapazitäten auch über den ganzen Verlauf der Leitung L verteilt werden.

## Patentansprüche

1. Monolithisch integrierter Ringoszillator mit einem Leitungstreiber (B) mit zwei Eingängen und zwei Ausgängen und einer die Ausgänge des Leitungstreibers auf die Eingänge des Leitungstreibers rückkoppeInden Doppelleitung, wobei die Doppelleitung (L) eine möglichst große Laufzeit (TL) und der Leitungstreiber (B) eine möglichst kleine Verzögerungszeit (TB) aufweist und die Doppelleitung und der Leitungstreiber auf ein und demselben Chip (Ch) integriert sind, und wobei die Doppelleitung (L) durch zwei nebeneinander über einer auf Massepotential liegenden Metallfläche verlaufende Leiterbahnen gebildet ist.

2. Monolithisch integrierter Oszillator nach Anspruch 1,
dadurch gekennzeichnet,
daß die Periodendauer der erzeugten Oszillatorschwingung dem Doppelten der Summe aus der Verzögerungszeit (TB) des Leitungstreibers (B) und der Laufzeit (TL) der Doppelleitung (L) entspricht.

3. Monolithisch integrierter Oszillator nach Anspruch 1 oder 2,
dadurch gekennzeichnet,
daß die Laufzeit (TL) der Doppelleitung (L) grösser als die Verzögerungszeit (TB) des Leitungstreibers (B) ist.

4. Monolithisch integrierter Oszillator nach einem der Ansprüche 1 bis 3,
dadurch gekennzeichnet,
daß das Oszillatorsignal über einen Auskoppelverstärker (A) zum Ausgang (OUT', OUT") der Oszillatorschaltung geführt ist.

5. Monolithisch integrierter Oszillator nach Anspruch 4,
dadurch gekennzeichnet,
daß Leitungstreiber (B) und Auskoppelverstärker (A) mit gleichartigen Treiberschaltungen realisiert sind.

6. Monolithisch integrierter Oszillator nach einem der vorhergehenden Ansprüche,
dadurch gekennzeichnet,
daß die Doppelleitung (L) mit Kapazitäten (QL1, QL2) belastet ist.

7. Monolithisch integrierter Oszillator nach Anspruch 6,
dadurch gekennzeichnet,
daß die Doppelleitung (L) mit steuerbaren Kapazitäten (QL1, QL2) belastet ist.

## Claims

1. Monolithically integrated ring oscillator having a line driver (B) having two inputs and two outputs and a two-wire line which feeds the outputs of the line driver back to the inputs of the line driver,
in which the two-wire line (L) has the longest possible transit time (TL) and the line driver (B) has the shortest possible delay time (TB) and the two-wire line and the line driver are integrated on one and the same chip (Ch), and in which the two-wire line (L) is formed by two interconnects running next to one another above a metal area which is at earth potential.

2. Monolithically integrated oscillator according to Claim 1,
characterized
in that the period of the oscillator oscillation that is generated corresponds to twice the sum of the delay time (TB) of the line driver (B) and the transit time (TL) of the two-wire line (L).

3. Monolithically integrated oscillator according to Claim 1 or 2,
characterized
in that the transit time (TL) of the two-wire line (L) is greater than the delay time (TB) of the line driver (B).

4. Monolithically integrated oscillator according to one of Claims 1 to 3,
characterized
in that the oscillator signal is passed via a coupling-out amplifier (A) to the output (OUT', OUT") of the oscillator circuit.

5. Monolithically integrated oscillator according to Claim 4,
characterized
in that the line driver (B) and the coupling-out amplifier (A) are realized with identical driver circuits.

6. Monolithically integrated oscillator according to one of the preceding claims,
characterized
in that the two-wire line (L) is loaded by capacitance elements (QL1, QL2).

7. Monolithically integrated oscillator according to Claim 6,
characterized
in that the two-wire line (L) is loaded by controllable capacitance elements (QL1, QL2).

## Revendications

1. Oscillateur annulaire intégré monolithiquement,
comportant un circuit d'attaque de ligne (B) avec deux entrées et avec deux sorties et une double ligne couplant en rétroaction les sorties du circuit d'attaque de ligne sur les entrées du circuit d'attaque de ligne,
dans lequel la double ligne (L) a un temps de propagation (TL) le plus grand possible et le circuit d'attaque de ligne (B) a un temps de retard (TB) le plus petit possible et dans lequel la double ligne et le circuit d'attaque de ligne sont intégrés sur une seule et même puce (Ch), la double ligne (L) étant formée par deux pistes conductrices s'étendant l'une à côté de l'autre sur une surface métallique se trouvant au potentiel de masse.

2. Oscillateur annulaire intégré monolithiquement selon la revendication 1,
caractérisé par le fait que la période de l'oscillation d'oscillateur produite correspond au double de la somme du temps de retard (TB) du circuit d'attaque de ligne (B) et du temps de propagation (TL) sur la double ligne (L).

3. Oscillateur annulaire intégré monolithiquement selon la revendication 1 ou 2,
caractérisé par le fait que le temps de propagation (TL) sur la double ligne (L) est supérieur au temps de retard (TB) du circuit d'attaque de ligne (B).

4. Oscillateur annulaire intégré monolithiquement selon l'une des revendications 1 à 3,
caractérisé par le fait que le signal d'oscillateur est envoyé par l'intermédiaire d'un amplificateur de sortie (A) à la sortie (OUT', OUT") du circuit oscillateur.

5. Oscillateur annulaire intégré monolithiquement selon la revendication 4,
caractérisé par le fait que le circuit d'attaque de ligne (B) et l'amplificateur de sortie (A) sont mis en oeuvre avec des circuits d'attaque de même type.

6. Oscillateur annulaire intégré monolithiquement selon l'une des revendications précédentes,
caractérisé par le fait que la double ligne (L) est chargée avec des capacités (QL1, QL2).

7. Oscillateur annulaire intégré monolithiquement selon la revendication 6,
caractérisé par le fait que la double ligne (L) est chargée avec des capacités (QL1, QL2) pouvant être commandées.
